# EUROPÄISCHE PATENTSCHRIFT

(11) **EP 3 198 636 B1**
(45) Veröffentlichungstag und Bekanntmachung des Hinweises auf die Patenterteilung: **20.01.2021**
(21) Anmeldenummer: 14802358.3
(22) Anmeldetag: 13.11.2014
(51) Int. Cl.: H01L 23/40, H02M 7/00, H01L 25/11, H01L 25/07, H01L 23/00, H01L 23/473, H01L 23/433, H02M 7/483

(54) **SPANNVERBAND SOWIE EIN SUBMODUL FÜR EINEN UMRICHTER MIT DEM SPANNVERBAND**
PRESS PACK AS WELL AS A SUBMODULE FOR POWER CONVERTER IN A PRESS PACK CONFIGURATION
ASSEMBLAGE À PRESSION AINSI QU' UN SUB-MODULE POUR UN CONVERTISSEUR PUISSANT DANS UN ASSEMBLAGE À PRESSION

(43) Veröffentlichungstag der Anmeldung: 02.08.2017
(73) Patentinhaber: Siemens Aktiengesellschaft, 80333 München (DE)
(72) Erfinder: BÖHM, Matthias, 91564 Neuendettelsau (DE); BREHM, Holger Siegmund, 91052 Erlangen (DE); SCHMITT, Daniel, 90459 Nürnberg (DE)
(86) Internationale Anmeldenummer: PCT/EP2014/074502
(87) Internationale Veröffentlichungsnummer: WO 2016/074727

(56) Entgegenhaltungen:
- EP-A2- 2 402 989
- JP-A- H11 215 804
- JP-A- 2000 049 198
- JP-A- 2013 236 004

## Beschreibung

Die Erfindung betrifft einen Spannverband mit einer Anordnung mechanisch verspannter, stapelweise übereinander liegender Bauelemente, einer Spannvorrichtung zum Erzeugen mechanischer Druckkraft auf die Anordnung der Bauelemente sowie einem Druckstück zum Übertragen der mechanischen Druckkraft von der Spannvorrichtung auf die Anordnung.

Ein derartiger Spannverband ist aus der Druckschrift DE 10 2011 006 990 A1 bereits bekannt. Dort ist ein Säulenspannverband beschrieben, bei dem stapelweise übereinander angeordnete Leistungsdioden und Kühlkörper mittels als Druckplatten ausgebildeter Druckstücke und Spannschrauben miteinander mechanisch verspannt sind. Die mittels der Spannschrauben erzeugte Druckkraft wird dabei punktuell auf die Druckplatten übertragen. Dies führt bei dem bekannten Spannverband zu einer relativ inhomogenen Druckverteilung. Der im Bereich einer Mittelachse des Säulenspannverbandes erzeugte Druck ist wesentlich höher als der in dessen Randbereichen.

Aus der JP 2013 236004 A ist eine Vorrichtung mit einem mechanischen Spannverband und einer darin angeordneten Kühlplatte bekannt. Die Kühlplatte umfasst zur besseren Druckverteilung Konkavbereiche, die als relativ flache Ausnehmungen an der Oberfläche der Kühlplatte gebildet sind.

Aus der JP 2000 049198 A ist eine Anordnung bekannt, bei der ein äußeres Kühlelement eine Zellstruktur mit gleichartigen Zellen aufweist.

Die JP H11 215804 A offenbart einen mechanischen Spannverband mit mehreren Halbleiterelementen und Kühlelementen.

Eine weitere Kühlvorrichtung mit Kühlelementen ist aus der EP 2 402 989 A2 bekannt.
Die Aufgabe der Erfindung ist es, einen Spannverband der obigen Art vorzuschlagen, bei dem die Übertragung der Druckkraft möglichst homogen ist.

Die Aufgabe wird durch einen Spannverband gemäß Anspruch 1 gelöst.

Durch eine geeignete Wahl einer ortsabhängigen Anordnung der Zellwandstärken der Zellwände und/oder der Zellhohlräume der Zellen ist die Druckübertragung von der Spannvorrichtung auf die Anordnung der Bauelemente vorteilhaft derart gezielt beeinflussbar, dass eine relativ homogene Druckverteilung erreicht wird. Grundsätzlich ist dabei zu beachten, dass eine dichtere Anordnung der Zellwände, also kleinere Volumina der Zellen in gewissen Bereichen des Druckübertragungskörpers für eine verhältnismäßig starre Struktur des Druckverteilungskörpers in diesen Bereichen sorgt.
Entsprechend ist die Elastizität der Zellwände durch eine geeignete Wahl der Zellwandstärke (Zellwanddicke) ebenfalls gezielt beeinflussbar. Dadurch ist insgesamt die Druckkraftübertragung mittels des Druckverteilungskörpers ortsabhängig gezielt steuerbar.

Dies ist von besonderer Bedeutung, falls die Bauelemente beispielsweise parallelgeschaltete Halbleiter-Chips sind, die eine relativ große Fläche aufweisen und zudem dünn und spröde sind. Inhomogenitäten können in solchen Fällen zu einer Beschädigung der Bauelemente führen. Zudem sind hinsichtlich der Größe der zu verspannenden Bauteile das Druckstück und der ihm zugeordnete Druckverteilungskörper beliebig skalierbar. Der Vorteil des erfindungsgemäßen Spannverbandes ist demnach auf Bauelemente beliebiger Größe anwendbar.

Gemäß einer Ausführungsform der Erfindung erstrecken sich alle Zellwände quer zu einer Grundfläche des Druckverteilungskörpers. Insbesondere ist es denkbar, dass sich die Zellwände parallel zueinander erstrecken. Beispielsweise können sich alle Zellwände im Wesentlichen, das heißt bis auf technisch nicht zu beherrschende Abweichungen, senkrecht zu der Grundfläche des Druckverteilungskörpers bzw. des Spannverbandes erstrecken. Diese Ausführungsform hat den Vorteil des besonders einfachen und daher kostengünstigen Aufbaus. Die Herstellung kann beispielsweise mittels Strangpressen erfolgen.

Die Grundfläche des Druckverteilungskörpers wird hierbei als diejenige Fläche verstanden, die sich senkrecht zu der Richtung der auf den Spannverband ausgeübten Druckkraft erstreckt.

Gemäß einer weiteren Ausführungsform der Erfindung erstrecken sich die Zellwände des Druckverteilungskörpers in allen drei Dimensionen. Dies bedeutet, dass die Zellwände jeweils in beliebige Richtungen weisen. Dadurch ergeben sich besonders vielfältige Möglichkeiten für die Beeinflussung der Druckverteilung.

Gemäß einer Ausführungsform sind die Zellwände stückweise planear, das heißt die Zellen weisen die Form von Polyedern auf.

Gemäß der Erfindung bilden die Zellen eine mehrschichtige Zellstruktur. Dies bedeutet, dass die Zellen des Druckverteilungskörpers im Allgemeinen in mehreren Schichten auch übereinander angeordnet sind. Es ist dabei denkbar, die Herstellung eines solchen Druckverteilungskörpers mittels eines sogenannten 3D-Druckers durchzuführen. Mittels eines aus mehreren Schichten gebildeten Druckverteilungskörpers ist eine besonders homogene Druckverteilung möglich.

Bevorzugt ist der Druckverteilungskörper aus einem Metall. Grundsätzlich kann der Druckverteilungskörper jedoch aus jedem geeigneten Material oder Materialkombination gefertigt sein.

Bevorzugt weist der Druckverteilungskörper eine konstante Höhe auf. Dies erlaubt eine einfachere Fertigung und Dimensionierung des Spannverbandes.

Um den Druck auf die Bauelemente der Anordnung möglichst homogen zu verteilen, kann die Zellwandstärke der Zellen bezüglich einer Mittelachse des Druckverteilungskörpers von innen nach außen zunehmen. Zumindest einige mittelachsennahe Zellen weisen dabei Zellwände mit kleinerer Zellwandstärke als Zellwände von wenigstens einigen mittelachsenfernen Zellen.

Es ist in diesem Zusammenhang zu erwähnen, dass eine einzelne Zelle im Allgemeinen mehrere Zellwände aufweist, wobei die Zellwände der Zelle im Allgemeinen unterschiedliche Zellwandstärken aufweisen können.

Gemäß einer weiteren vorteilhaften Ausführungsform der Erfindung umfasst die Anordnung wenigstens ein Halbleiterelement, wobei das Halbleiterelement parallel angeordnete Press-Pack-Halbleiter umfasst (siehe dazu beispielsweise die Druckschrift EP 1 403 923 A1). Damit setzt sich das Halbleiterelement aus nebeneinander angeordneten Halbleitermodulen zusammen. Die Halbleitermodule bilden eine Parallelschaltung von elektrischen Bauteilen. Beispielsweise kann es sich dabei um IGBT-Halbleiter, Dioden oder Thyristorelemente oder entsprechende zusammengesetzte, über eigene Gehäuse verfügende Module handeln. Die Oberfläche solcher Halbleitermodule kann beispielsweise einen Durchmesser von 6 bis 9 mm aufweisen. Die zu verpressende Oberfläche der Bauteile kann zwischen 400 und 1000 cm² betragen.

Zur Kühlung des wenigstens einen Halbleiterelementes umfasst die Anordnung ferner vorteilhaft wenigstens eine Kühlplatte aus elektrisch leitfähigem Material, wobei die wenigstens eine Kühlplatte am Halbleiterelement anliegend angeordnet ist, so dass ein elektrischer Kontakt zwischen dem Halbleiterelement und der Kühlplatte besteht. Die Kühlplatte dient zur Ableitung der im Halbleiterelement entstehenden Wärme. Diese Wärme entsteht insbesondere durch den elektrischen Durchlasswiderstand des Halbleiterelementes. Geeigneterweise besteht die Kühlplatte aus einem auch wärmeleitenden Material, bevorzugt einem Material mit einer Wärmeleitfähigkeit von über 200 W/(mK), wie beispielsweise einem Metall oder einer Metalllegierung.

Die Anordnung kann auch mehrere übereinander angeordnete Halbleiterelemente umfassen, wobei jedem der Halbleiterelemente wenigstens eine Kühlplatte zugeordnet ist und die Halbleiterelemente eine elektrische Reihenschaltung ausbilden.

Besonders bevorzugt ist es, wenn jedem Halbleiterelement zwei Kühlplatten zugeordnet sind, die beidseitig des jeweiligen Halbleiterelementes angeordnet sind. Auf diese Weise kann die Wärmeabfuhr zu beiden Seiten des Halbleiterelementes erfolgen. Da die Kühlplatten aus elektrisch leitfähigem Material hergestellt sind, kann die elektrische Kontaktierung zwischen den Halbleiterelementen mittels der Kühlplatten hergestellt sein.

Zur weiteren Verbesserung der Homogenität der Druckkraftübertragung wird als besonders vorteilhaft angesehen, ein Gegendruckstück vorzusehen, das dem Druckstück bezüglich der Anordnung der Bauelemente gegenüberliegend angeordnet ist. Das Gegendruckstück kann, muss jedoch nicht, gleich aufgebaut sein, wie das Druckstück. Insbesondere können beide kegelartig, kegelstumpfartig, trapezartig oder in jeder anderen geeigneten Form gebildet sein. Dem Gegendruckstück ist vorteilhaft ein zweiter Druckverteilungskörper zugeordnet. Der zweite Druckverteilungskörper ist beispielsweise zum ersten Druckverteilungskörper gleichartig aufgebaut.

Ferner betrifft die Erfindung ein Submodul eines Umrichters mit wenigstens einer Reihenschaltung von Leistungshalbleiterschalteinheiten, die jeweils einen ein- und abschaltbaren Leistungshalbleiter mit gleicher Durchlassrichtung aufweisen und jeweils entgegen der besagten Durchlassrichtung leitfähig sind und einem dazu in einer Parallelschaltung angeordneten Energiespeicher.

Ein Beispiel eines solchen Submoduls ist aus der DE 101 030 31 A1 bekannt.

Ausgehend von dem bekannten Submodul ist eine weitere Aufgabe der Erfindung, ein Submodul der vorstehend genannten Art vorzuschlagen, das möglichst wenig fehleranfällig ist.

Die Aufgabe wird erfindungsgemäß durch ein artgemäßes Submodul gelöst, bei dem die Reihenschaltung der Leistungshalbleiterschalteinheiten in einem zuvor beschriebenen Spannverband realisiert ist.

Durch die Verwendung des erfindungsgemäßen Druckstücks kann das Risiko einer Beschädigung und damit eines Fehlers der Halbleiter infolge inhomogener Druckverteilung vermindert werden.

Die Erfindung wird im Folgenden anhand eines in den Figuren 1 bis 3 dargestellten Ausführungsbeispiels des erfindungsgemäßen Spannverbandes bzw. Submoduls näher erläutert.
- Figur 1: zeigt in einer schematischen Seitendarstellung ein Ausführungsbeispiel eines erfindungsgemäßen Spannverbandes;
- Figur 2: zeigt in einer schematischen Draufsicht ein Ausführungsbeispiel eines Druckverteilungskörpers des Spannverbandes aus Figur 1;
- Figur 3: zeigt in einer schematischen Darstellung ein Ausführungsbeispiel eines erfindungsgemäßen Submoduls.

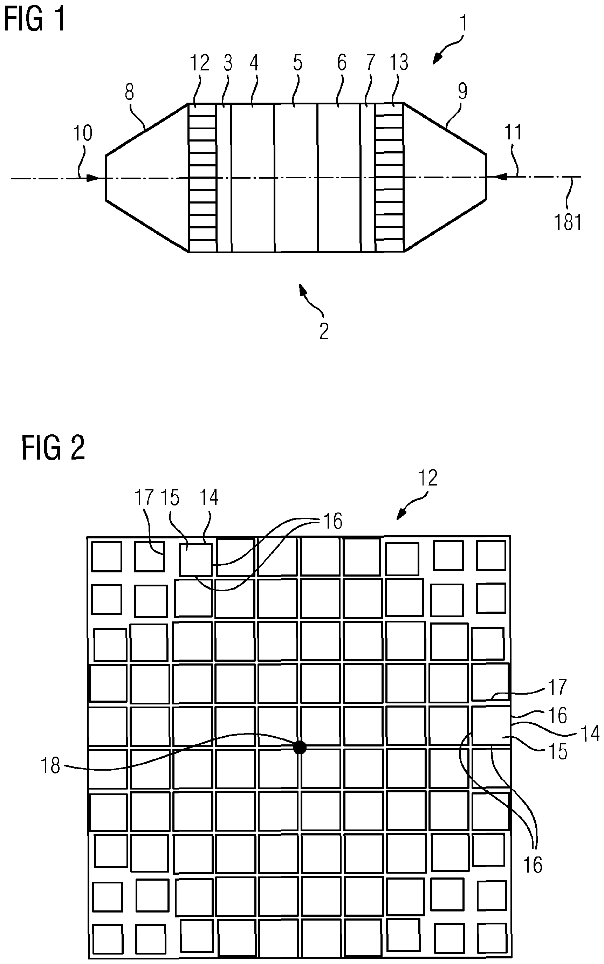

Im Einzelnen ist in Figur 1 ein Ausführungsbeispiel eines Spannverbandes 1 in einer schematischen Seitenansicht dargestellt. Der Spannverband 1 umfasst eine Anordnung 2 miteinander mechanisch verspannter und stapelweise übereinander liegender Bauelemente 3, 4, 5, 6, 7. Der Spannverband 1 umfasst ferner ein erstes Druckstück 8 und ein zweites Druckstück 9, wobei das zweite Druckstück 9 als ein Gegendruckstück zum ersten Druckstück 8 bezüglich der Anordnung 2 gegenüberliegend angeordnet ist. Mittels einer in Figur 1 nicht dargestellten Spannvorrichtung wird eine Kraft auf die Druckstücke 8, 9 ausgeübt, die in Figur 1 durch Pfeile 10, 11 angedeutet ist. Die Druckkraft 10 bzw. die Gegendruckkraft 11 wird mittels der Druckstücke 8, 9 auf die Anordnung der Bauelemente 3 - 7 übertragen. Die Anordnung 2 der Bauelemente umfasst eine erste Kühlplatte 3 und eine zweite Kühlplatte 7, zwischen denen sich im in Figur 1 dargestellten Ausführungsbeispiel Halbleiterelemente 3 - 6 befinden. Im Rahmen der Erfindung kann die Anordnung 2 der Bauelemente jedoch ebenso eine beliebige Anzahl von Kühlplatten und Halbleiterelementen aufweisen, die in einer beliebigen geeigneten Anordnung übereinanderliegend angeordnet sind. Zwischen dem ersten Druckstück 8 und der ersten Kühlplatte 3 ist ein erster Druckverteilungskörper 12 angeordnet, das dem ersten Druckstück 8 zugeordnet ist. Der erste Druckverteilungskörper 12 sorgt für eine homogene Verteilung der Druckkraft 10 auf die Anordnung 2 der Bauelemente. Die im Wesentlichen punktuell auf das Druckstück 8 ausgeübte Kraft 10 kann demnach mittels des Druckverteilungskörpers 12 relativ homogen auf die Anordnung 2 übertragen werden. Dazu kann Druckverteilung mittels des Druckverteilungskörpers 12 gezielt beeinflusst werden, so dass sie in der sich zu einer durch eine strichpunktierte Linie 181 dargestellten Mittelachse des Spannverbandes senkrecht erstreckenden Ebene möglichst homogen verteilt ist.

Dementsprechend umfasst der Spannverband 1 einem dem ersten Druckverteilungskörper 12 gegenüberliegend angeordneten zweiten Druckverteilungskörper 13, der entsprechend dem Gegendruckstück 9 zugeordnet ist. Der erste Druckverteilungskörper 12 und der zweite Druckverteilungskörper 13 können gleichartig aufgebaut sein, können aber auch einen unterschiedlichen Aufbau aufweisen.

In Figur 2 ist eine Draufsicht des ersten Druckverteilungskörpers 12 des Spannverbandes 1 aus Figur 1 schematisch dargestellt. In dem in Figur 2 dargestellten Ausführungsbeispiel des ersten Druckverteilungskörpers 12 weist der erste Druckverteilungskörper 12 eine Zellstruktur auf, wobei die Zellstruktur durch aneinander anliegende Zellen 14 gebildet ist. Jede Zelle 14 wird durch einen Zellhohlraum 15 begrenzende Zellwände 16, 17 gebildet. Zur Übersichtlichkeit sind in der Figur 2 lediglich zwei Zellen 14 der Zellstruktur des Druckverteilungskörpers 12 mit Bezugszeichen versehen. In dem in Figur 2 dargestellten Beispiel erstrecken sich die Zellwände 16, 17 der Zellen 14 senkrecht zu einer Grundebene des Druckverteilungskörpers 12. Alle Zellwände 16, 17 der Zellen 14 erstrecken sich zudem parallel zueinander. Die Zellwände 16, 17 der Zellen 14 weisen im Allgemeinen unterschiedliche Zellwandstärken bzw. - dicken auf. Es ist aus der Figur erkennbar, dass die Zellwände 17 eine höhere Zellwandstärke aufweisen als die denselben Zellen 14 zugeordneten Zellwände 16. Durch eine gezielte Beeinflussung der Zellwandstärke der Zellwände 16, 17 kann die Nachgiebigkeit der entsprechenden Zellwände 16, 17 gezielt beeinflusst werden. Dadurch kann auch die Druckkraftübertragung in den entsprechenden Bereichen des Druckverteilungskörpers 12 bestimmt werden. Eine geeignete Wahl der Zellwandstärken der Zellwände 14 erlaubt demnach eine homogene Verteilung der Druckkraft auf die Anordnung 2 der Bauelemente.

In dem in Figur 2 dargestellten Ausführungsbeispiel des Druckverteilungskörpers 12 nimmt die Zellwandstärke der Zellen 14 von einem Mittelpunkt 18 des Druckverteilungskörpers 12 nach außen hin zu.

Insbesondere sind die Zellwände der Zellen in den Eckbereichen des im dargestellten Ausführungsbeispiel quadratischen Druckverteilungkörpers 12 dicker als die Zellwände der Zellen im Bereich des Mittelpunktes 18.

Aus dem in Figur 2 dargestellten Beispiel des Druckverteilungskörpers 12 ist ersichtlich, dass, aufgrund der gewählten niedrigeren Steifigkeit der Zellwände im Bereich des Mittelpunktes 18, dort verhältnismäßig weniger Kraft übertragen wird, als in den Rand- bzw. Eckbereichen des Druckverteilungskörpers 12. Dies gleicht den Effekt aus, dass aufgrund der punktuellen Kraftübertragung auf das Druckstück im Bereich der Mittelachse 181 eine höhere Kraft auf das Druckstück bzw. das Gegendruckstück ausgeübt wird.

Die Wahl der Größe der Zellhohlräume 15 sowie der Zellwandstärken kann beispielsweise anhand von Simulationen bestimmt werden und ist nicht auf das in Figur 2 dargestellte Beispiel beschränkt.

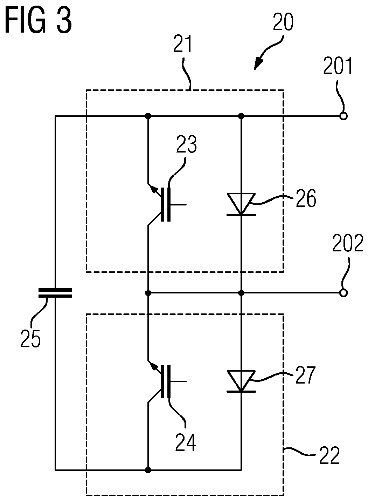

In Figur 3 ist ein Ausführungsbeispiel eines erfindungsgemäßen Submoduls 20 dargestellt. Das Submodul 20 ist zweipolig ausgebildet, wobei die Pole (der Klemmen) des Submoduls 20 in Figur 3 mit den Bezugszeichen 201 beziehungsweise 202 gekennzeichnet sind. Das Submodul 20 bildet einen Teil eines nicht grafisch in Figur 3 dargestellten Umrichters, wobei eine Mehrzahl von weiteren Submodulen 20, die zum Submodul 20 gleichartig aufgebaut sind, unter Ausbildung eines Umrichterphasenzweiges in Reihe geschaltet sind. Das Submodul 20 weist eine Reihenschaltung von Leistungshalbleiterschalteinheiten 21, 22 auf, wobei jeder der beiden Leistungshalbleiterschalteinheiten 21 bzw. 22 einen Leistungshalbleiterschalter 23 bzw. 24 und eine dazu gegensinnig parallel geschaltete Diode 26 bzw. 27 umfasst. Das Submodul 20 umfasst ferner einen Speicherkondensator 25, der parallel zu der Reihenschaltung der Leistungshalbleiterschalteinheiten 21, 22 angeordnet ist. Die Reihenschaltung der Leistungshalbleiterschalteinheiten 21, 22 ist in Form eines in den Figuren 1 und 2 dargestellten Spannverbandes 1 ausgeführt.

## Patentansprüche

1. Spannverband (1) mit einer Anordnung (2) mechanisch verspannter, stapelweise übereinander liegender Bauelemente (3 - 7), einer Spannvorrichtung zum Erzeugen mechanischer Druckkraft (10, 11) auf die Anordnung (2) der Bauelemente (3 - 7) sowie einem Druckstück (8) zum Übertragen der mechanischen Druckkraft (10, 11) von der Spannvorrichtung auf die Anordnung (2), wobei dem Druckstück (8) ein Druckverteilungskörper (12) mit einer Zellstruktur zugeordnet ist, wobei die Zellstruktur durch aneinander anliegende Zellen (14) mit Zellhohlräume (15) begrenzenden, Druck übertragenden Zellwänden (16, 17) gebildet ist, wobei die Zellwände (16, 17) unterschiedliche Zellwandstärken und/oder die Zellhohlräume (15) unterschiedliche Volumina aufweisen, **dadurch gekennzeichnet, dass**
die Zellen (14) der Zellstruktur des Druckverteilungskörpers (12) eine mehrschichtige Zellstruktur bilden, derartig dass die Zellen (14) des Druckverteilungskörpers (12) im Allgemeinen in mehreren Schichten auch übereinander angeordnet sind.

2. Spannverband (1) nach Anspruch 1, wobei alle Zellwände (16, 17) sich quer zu einer Grundfläche des Druckverteilungskörpers (12) erstrecken.

3. Spannverband (1) nach Anspruch 1, wobei die Zellwände (16, 17) sich in allen drei Dimensionen erstrecken.

4. Spannverband (1) nach einem der vorangehenden Ansprüche, wobei der Druckverteilungskörper (12) aus einem Metall ist.

5. Spannverband (1) nach einem der vorangehenden Ansprüche, wobei der Druckverteilungskörper (12) eine konstante Höhe aufweist.

6. Spannverband (1) nach einem der vorangehenden Ansprüche, wobei die Zellwandstärke der Zellen (14) bezüglich einer Mittelachse des Druckverteilungskörpers von innen nach außen zunimmt.

7. Spannverband (1) nach einem der vorangehenden Ansprüche, wobei die Anordnung (2) der Bauelemente (3 - 7) ein Halbleiterelement (4) umfasst.

8. Spannverband (1) nach Anspruch 7, wobei die Anordnung (2) der Bauelemente (3 - 7) wenigstens eine Kühlplatte (3) aus elektrisch leitfähigem Material umfasst, wobei die wenigstens eine Kühlplatte (3) am Halbleiterelement (4) anliegend angeordnet ist, so dass ein elektrischer Kontakt zwischen dem Halbleiterelement (4) und der Kühlplatte (3) besteht.

9. Spannverband (1) nach Anspruch 8, wobei die Anordnung (2) der Bauelemente (3 -7) eine Mehrzahl von Halbleiterelementen (4 - 6) umfasst, wobei jedem Halbleiterelement wenigstens eine Kühlplatte zugeordnet ist und die Halbleiterelemente (4 - 6) eine elektrische Reihenschaltung ausbilden.

10. Spannverband (1) nach Anspruch 9, wobei jedem Halbleiterelement zwei Kühlplatten zugeordnet sind, die beidseitig des Halbleiterelementes angeordnet sind.

11. Submodul (20) eines Umrichters mit wenigstens einer Reihenschaltung von Leistungshalbleiterschalteinheiten (21, 22), die jeweils einen ein- und abschaltbaren Leistungshalbleiter (23, 24) mit gleicher Durchlassrichtung aufweisen und jeweils entgegen der besagten Durchlassrichtung leitfähig sind und einem dazu in einer Parallelschaltung angeordneten Energiespeicher (25),
**dadurch gekennzeichnet, dass**
die Reihenschaltung der Leistungshalbleiterschalteinheiten (21, 22) in einem Spannverband (1) gemäß einem der Ansprüche 1 bis 10 realisiert ist.

## Claims

1. Clamping assembly (1) comprising an arrangement (2) of mechanically clamped components (3 - 7) stacked one over another, a clamping device for generating mechanical pressure force (10, 11) on the arrangement (2) of the components (3 - 7), and a pressure piece (8) for transmitting the mechanical pressure force (10, 11) from the clamping device to the arrangement (2), wherein a pressure distributing body (12) having a cell structure is assigned to the pressure piece (8), wherein the cell structure is formed by cells (14) bearing against one another and having cell walls (16, 17) which delimit cell cavities (15) and transmit pressure, wherein the cell walls (16, 17) have different cell wall thicknesses and/or the cell cavities (15) have different volumes,
**characterized in that**
the cells (14) of the cell structure of the pressure distributing body (12) form a multi-layered cell structure, in such a way that the cells (14) of the pressure distributing body (12) are generally also arranged one over another in a plurality of layers.

2. Clamping assembly (1) according to Claim 1, wherein all the cell walls (16, 17) extend transversely with respect to a basic area of the pressure distributing body (12).

3. Clamping assembly (1) according to Claim 1, wherein the cell walls (16, 17) extend in all three dimensions.

4. Clamping assembly (1) according to any of the preceding claims, wherein the pressure distributing body (12) is composed of a metal.

5. Clamping assembly (1) according to any of the preceding claims, wherein the pressure distributing body (12) has a constant height.

6. Clamping assembly (1) according to any of the preceding claims, wherein the cell wall thickness of the cells (14) increases from the inner region outwards with respect to a centre axis of the pressure distributing body.

7. Clamping assembly (1) according to any of the preceding claims, wherein the arrangement (2) of the components (3 - 7) comprises a semiconductor element (4).

8. Clamping assembly (1) according to Claim 7, wherein the arrangement (2) of the components (3 - 7) comprises at least one cooling plate (3) composed of electrically conductive material, wherein the at least one cooling plate (3) is arranged in a manner bearing against the semiconductor element (4), such that there is an electrical contact between the semiconductor element (4) and the cooling plate (3).

9. Clamping assembly (1) according to Claim 8, wherein the arrangement (2) of the components (3 - 7) comprises a plurality of semiconductor elements (4 - 6), wherein at least one cooling plate is assigned to each semiconductor element and the semiconductor elements (4 - 6) form an electrical series circuit.

10. Clamping assembly (1) according to Claim 9, wherein two cooling plates are assigned to each semiconductor element, said cooling plates being arranged on both sides of the semiconductor element.

11. Submodule (20) of a convertor comprising at least one series circuit formed by power semiconductor switching units (21, 22), each of which has a power semiconductor (23, 24) with the same forward direction, said power semiconductor being able to be switched on and off, and each of which is conductive counter to said forward direction, and comprising an energy store (25) arranged in a parallel circuit with respect thereto,
**characterized in that**
the series circuit formed by the power semiconductor switching units (21, 22) is realised in a clamping assembly (1) according to any of Claims 1 to 10.

## Revendications

1. Assemblage (1) serré, comprenant un agencement (2) de composants (3 à 7) serrés mécaniquement et disposés les uns sur les autres à la manière d'une pile, un système de serrage pour produire une force (10, 11) de poussée mécanique sur l'agencement (2) des composants (3 à 7), ainsi qu'une pièce (8) de poussée pour transmettre la force (10, 11) de poussée mécanique du système de serrage à l'agencement (2),
dans lequel
à la pièce (8) de poussée est associé un corps (12) de répartition de la poussée ayant une structure cellulaire, la structure cellulaire étant formée de cellules (14) s'appliquant les unes aux autres et ayant des parois (16, 17) de cellule, délimitant des espaces (15) vides de cellule et transmettant la pression, les parois (16, 17) de cellule ayant des épaisseurs de paroi de cellule différentes et/ou les espaces (15) vides de cellule ayant des volumes différents,
**caractérisé en ce que**
les cellules (14) de la structure cellulaire du corps (12) de répartition de pression forment une structure cellulaire à plusieurs couches, de manière à ce que les cellules (14) du corps (12) de répartition de la pression soient disposées, d'une manière générale, en plusieurs couches également les unes sur les autres.

2. Assemblage (1) de serrage suivant la revendication 1, dans lequel toutes les parois (16, 17) des cellules s'étendent transversalement à une surface de base du corps (12) de répartition de la pression.

3. Assemblage (1) de serrage suivant la revendication 1, dans lequel les parois (16, 17) des cellules s'étendent dans toutes les trois dimensions.

4. Assemblage (1) de serrage suivant l'une des revendications précédentes, dans lequel le corps (12) de répartition de la pression est en métal.

5. Assemblage (1) de serrage suivant l'une des revendications précédentes, dans lequel le corps (12) de répartition de la pression a une hauteur constante.

6. Assemblage (1) de serrage suivant l'une des revendications précédentes, dans lequel l'épaisseur des parois des cellules (14) augmente, rapporté à un axe médian du corps de répartition de la pression, de l'intérieur vers l'extérieur.

7. Assemblage (1) de serrage suivant l'une des revendications précédentes, dans lequel l'agencement (2) des composants (3 à 7) comprend un élément (4) à semi-conducteur.

8. Assemblage (1) de serrage suivant la revendication 7, dans lequel l'agencement (2) des composants (3 à 7) comprend au moins une plaque (3) de refroidissement en un matériau conducteur de l'électricité, la au moins une plaque (3) de refroidissement étant disposée de manière à s'appliquer à l'élément (4) à semi-conducteur, de manière à avoir un contact électrique entre le composant (4) à semi-conducteur et la plaque (3) de refroidissement.

9. Assemblage (1) de serrage suivant la revendication 8, dans lequel l'agencement (2) des composants (3 à 7) comprend une pluralité d'éléments (4 à 6) à semiconducteurs, au moins une plaque de refroidissement étant associée à chaque élément à semi-conducteur et les éléments (4 à 6) à semi-conducteur constituant un circuit électrique série.

10. Assemblage (1) de serrage suivant la revendication 9, dans lequel deux plaques de refroidissement sont associées à chaque élément à semi-conducteur et sont disposées de part et d'autre de l'élément à semi-conducteur.

11. Sous-module (20) d'un onduleur ayant au moins un circuit série d'unités (21, 22) d'interruption à semi-conducteur de puissance, qui ont chacune un semi-conducteur (23, 24) de puissance, pouvant être passant et pouvant être bloqué, ayant le même sens passant et qui sont chacune conductrice dans le sens contraire audit sens passant, et un accumulateur (25) d'énergie monté suivant un circuit en parallèle,
**caractérisé en ce que**
le circuit série des unités (21, 22) d'interruption à semi-conducteur de puissance est réalisé en un assemblage (1) de serrage suivant l'une des revendications 1 à 10.
